# EUROPEAN PATENT APPLICATION

(11) **EP 4 401 134 A1**
(43) Date of publication of application: **17.07.2024**
(21) Application number: 23220349.7
(22) Date of filing: 27.12.2023
(51) Int. Cl.: H01L 23/528, G06F 30/392, H01L 27/02, H01L 27/118

(54) **INTEGRATED CIRCUIT INCLUDING SWITCH CELL AREA**

(30) Priority: 11.01.2023 KR 20230004321; 13.04.2023 KR 20230048992
(71) Applicant: Samsung Electronics Co., Ltd., Suwon-si, Gyeonggi-do 16677 (KR)
(72) Inventor: YU, Jisu, 16677 Suwon-si, Gyeonggi-do (KR); DO, Jungho, 16677 Suwon-si, Gyeonggi-do (KR); JUNG, Sungyup, 16677 Suwon-si, Gyeonggi-do (KR)
(74) Representative: Kuhnen & Wacker Patent- und Rechtsanwaltsbüro PartG mbB

(57) **Abstract**

An integrated circuit includes: a plurality of first power rails extending in a first horizontal direction and configured to provide a first power supply voltage that is applied thereto; a plurality of second power rails extending in the first horizontal direction and configured to provide a second power supply voltage that is applied thereto; and a power line in a switch cell area and extending in the first horizontal direction the power line being configured to provide a global power supply voltage that is applied thereto, wherein the plurality of first power rails and the plurality of second power rails are alternately arranged in a second horizontal direction vertical to the first horizontal direction, wherein the plurality of first power rails, the plurality of second power rails, and the power line form a front-side pattern on a same layer, and wherein the power line is provided between two second power rails adjacent to each other in the first horizontal direction, among the plurality of second power rails.

## Description

### BACKGROUND

The disclosure relates to an integrated circuit, and more particularly, to an integrated circuit including a switch cell area to which a global power supply voltage is applied.

Recently, as integrated circuits have become complicated in configuration and a semiconductor manufacturing process has been finely subdivided, a number of semiconductor devices have been integrated into an integrated circuit. In integrated circuits, a gate length of devices is progressively reduced and a width of a wiring connecting semiconductor devices with each other is reduced also. Particularly, a method of placing power line patterns for supplying power to an integrated circuit has been researched.

### SUMMARY

Embodiments provide an integrated circuit including a switch cell area to which a global power supply voltage is applied.

According to an aspect of an embodiment, an integrated circuit includes: a plurality of first power rails extending in a first horizontal direction and configured to provide a first power supply voltage that is applied thereto; a plurality of second power rails extending in the first horizontal direction and configured to provide a second power supply voltage that is applied thereto; and a power line in a switch cell area and extending in the first horizontal direction the power line being configured to provide a global power supply voltage that is applied thereto, wherein the plurality of first power rails and the plurality of second power rails are alternately arranged in a second horizontal direction vertical to the first horizontal direction, wherein the plurality of first power rails, the plurality of second power rails, and the power line form a front-side pattern on a same layer, and wherein the power line is provided between two second power rails adjacent to each other in the first horizontal direction, among the plurality of second power rails.

According to an aspect of an embodiment, an integrated circuit includes: a plurality of logic cell areas, each of the plurality of logic cell areas including a logic cell; a switch cell area between the plurality of logic cell areas; a plurality of first power rails extending in a first horizontal direction and configured to provide a first power supply voltage that is applied thereto; and a plurality of second power rails extending in the first horizontal direction and configured to provide a second power supply voltage that is applied thereto, wherein the switch cell area includes: a switch cell including: a power line configured to provide a global power supply voltage that is applied thereto, and a plurality of P-type transistors connected to the plurality of first power rails; a power tap cell including a global via structure electrically connecting the power line to a back-side pattern; and a switch dummy cell electrically separating the logic cell from the switch cell, and wherein two second power rails adjacent to each other in the first horizontal direction, among the plurality of second power rails, are cut off in the switch cell area.

According to an aspect of an embodiment, an integrated circuit includes: a plurality of logic cell areas, each of the plurality of logic cell areas including a logic cell; a switch cell area between the plurality of logic cell areas; a plurality of first power rails extending in a first horizontal direction and configured to provide a first power supply voltage that is applied thereto; and a plurality of second power rails extending in the first horizontal direction and configured to provide a second power supply voltage that is applied thereto, wherein the switch cell area includes: a switch cell including a power line configured to provide a global power supply voltage that is applied thereto, and a plurality of P-type transistors connected to the plurality of first power rails; a power tap cell including a global via structure electrically connecting the power line to a back-side pattern; and a switch dummy cell electrically separating the logic cell from the switch cell, and wherein an N-type well region including a jog pattern is provided in the switch dummy cell.

### BRIEF DESCRIPTION OF THE DRAWINGS

Embodiments will be more clearly understood from the following detailed description taken in conjunction with the accompanying drawings in which:
FIG. 1 is a layout diagram for describing an integrated circuit according to an embodiment;
FIG. 2 is an enlarged view of a region A of FIG. 1;
FIGS. 3A, 3B, and 3C are layout diagrams for describing a logic cell area and a switch cell area of an integrated circuit according to an embodiment;
FIG. 4 is a layout diagram for describing a logic cell area and a switch cell area of an integrated circuit according to an embodiment;
FIG. 5 is a layout diagram for describing a switch dummy cell in an integrated circuit according to an embodiment;
FIG. 6 is a layout diagram for describing a power tap cell in an integrated circuit according to an embodiment;
FIGS. 7A, 7B, and 8 are diagrams for describing a first metal layer, a via structure, and a back-side pattern in a switch cell area including a power tap cell;
FIG. 9 is a layout diagram for describing a power tap cell in an integrated circuit according to an embodiment;
FIGS. 10, 11A, and 11B are diagrams for describing a first metal layer, a via structure, and a back-side pattern in a switch cell area and a logic cell area each including a power tap cell;
FIG. 12 is a layout diagram for describing a power tap cell in an integrated circuit according to an embodiment;
FIGS. 13 and 14 are diagrams for describing a first metal layer, a via structure, and a back-side pattern in a power tap cell and a switch cell area including the power tap cell;
FIG. 15 is a layout diagram for describing an integrated circuit according to an embodiment;
FIG. 16 is a flowchart illustrating a method of manufacturing an integrated circuit, according to an embodiment; and
FIG. 17 is a block diagram illustrating a computing system including a memory storing a program, according to an embodiment.

### DETAILED DESCRIPTION

Hereinafter, embodiments will be described in detail with reference to the accompanying drawings. Like reference numerals refer to like elements in the drawings, and their repeated descriptions are omitted.

Herein, an X-axis direction may be referred to as a first horizontal direction, a Y-axis direction may be referred to as a second horizontal direction, and a Z-axis direction may be referred to as a vertical direction. Herein, a plane based on an X axis and a Y axis may be referred to as a horizontal surface, an element placed in a +Z-axis direction with respect to another element may be referred to as being placed above the other element, and an element placed in a -Z-axis direction with respect to another element may be referred to as being placed under the other element.

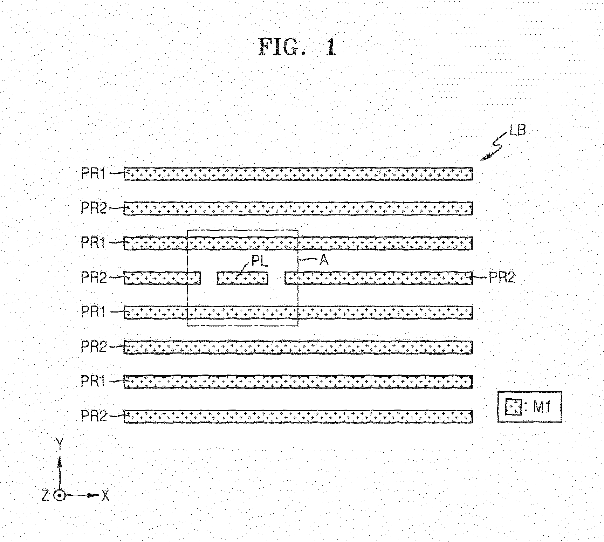

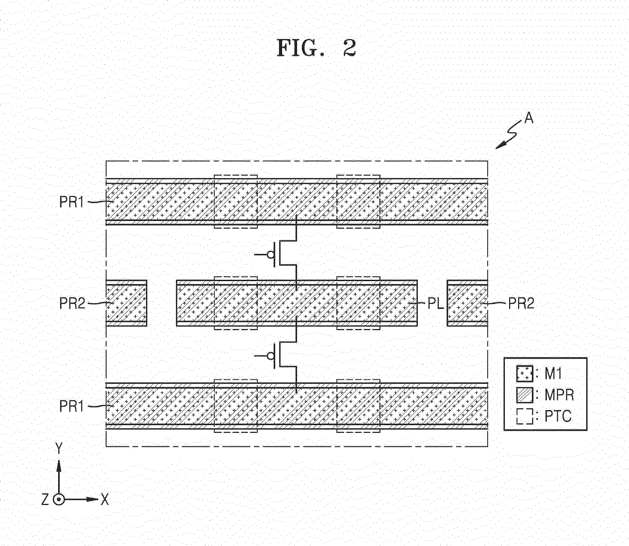

FIG. 1 is a layout diagram for describing an integrated circuit LB according to an embodiment. FIG. 2 is an enlarged view of a region A of FIG. 1. The region A of FIG. 2 may correspond to a switch cell area included in the integrated circuit LB. In FIG. 1, for convenience of description, it is illustrated that one switch cell area is in the integrated circuit LB, but embodiments of the disclosure are not limited thereto. A plurality of switch cell areas may be included in the integrated circuit LB and may be randomly arranged in the integrated circuit LB, or the plurality of switch cell areas may also be arranged continuously in the X-axis direction or the Y-axis direction.

A logic block may be implemented in the integrated circuit LB, and a plurality of metal layers stacked sequentially in the vertical direction may be formed in the integrated circuit LB. For example, in an embodiment, the integrated circuit LB may include a plurality of front metal layers where a front-side pattern is formed on a front side of a substrate. A second metal layer may be formed on a first metal layer M1, which is the lowermost metal layer, of the plurality of front metal layers, and a third metal layer may be formed on the second metal layer.

Patterns formed in each of the plurality of metal layers may include metal, conductive metal nitride, metal silicide, or a combination thereof. In the drawings, for convenience of illustration, only some layers may be illustrated.

Referring to FIG. 1, the integrated circuit LB may include a plurality of first power rails PR1 and a plurality of second power rails PR2, which configure a power distribution network. Standard cells (for example, a logic cell) in the integrated circuit LB may be supplied with supply voltages through the plurality of first power rails PR1 and the plurality of second power rails PR2. That is, the supply voltages supplied through the plurality of first power rails PR1 and the plurality of second power rails PR2 may be internal voltages of the integrated circuit LB. The plurality of first power rails PR1 may provide a first power supply voltage (for example, VDD) to the standard cells, and the plurality of second power rails PR2 may provide a second power supply voltage (for example, VSS or a ground voltage) to the standard cells.

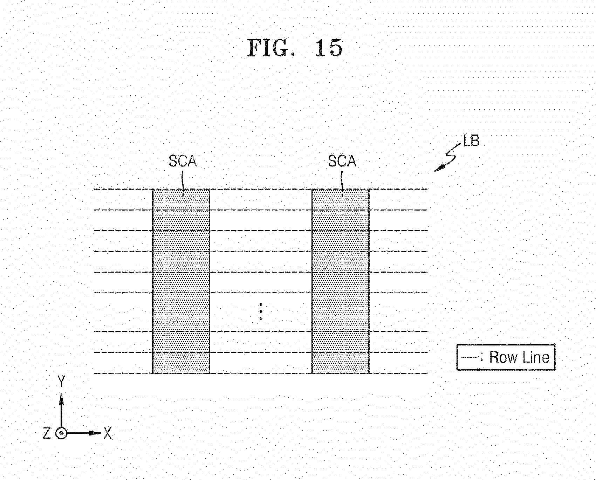

The plurality of first power rails PR1 and the plurality of second power rails PR2 may be provided as a conductive pattern which extends in the X-axis direction. The plurality of first power rails PR1 and the plurality of second power rails PR2 may be disposed at a boundary (for example, a row line of FIG. 15) of each of a plurality of rows of the integrated circuit LB and may be alternately arranged in the Y-axis direction. That is, the order of first power rail PR1-second power rail PR2-first power rail PR1-second power rail PR2 may be repeatedly arranged in the Y-axis direction.

A power line PL to which a global power supply voltage is applied may be formed in the switch cell area. For example, the global power supply voltage may be a power supply voltage supplied from the outside of the integrated circuit LB to the integrated circuit LB, and for example, the global power supply voltage may be an external voltage. The integrated circuit LB may include a lower pad and may be supplied with the global power supply voltage through the lower pad from the outside.

The plurality of first power rails PR1, the plurality of second power rails PR2, and the power line PL may be formed in the same metal layer, and for example, may be provided as a pattern of the first metal layer M1. However, the integrated circuit LB according to an embodiment is not limited to that the plurality of first power rails PR1, the plurality of second power rails PR2, and the power line PL are provided as the pattern of the first metal layer M1 and may be formed in an upper metal layer of the first metal layer M1.

The power line PL may be disposed between two second power rails PR2 arranged adjacent to each other in the X-axis direction among the plurality of second power rails PR2. Therefore, the power line PL may be disposed in the switch cell area, or in a row line (a boundary of a row) where the second power rail PR2 is disposed in a region except the switch cell area. That is, the power line PL may be disposed at a portion where the second power rail PR2 is cut off, in the switch cell area, and the first power rails PR1 and the power line PL are arranged in the order of first power rail PR1-power line PL-first power rail PR1 in the Y-axis direction, in the switch cell area.

Referring to FIGS. 1 and 2, a plurality of P-type transistors connected between the first power rail PR1 and the power line PL may be formed in the switch cell area. As the plurality of P-type transistors are turned on, the global power supply voltage provided through the power line PL may be supplied to the first power rail PR1.

An N-type transistor may not be formed and only P-type transistors may be formed in the switch cell area. Because the second power rail PR2 is cut off in the switch cell area, an N-type well region where P-type transistors are formed may be formed in the switch cell area to extend between two first power rails PR1 adjacent to each other in the Y-axis direction. That is, an N-type active region where an N-type transistor is formed may not be formed in the switch cell area.

In an embodiment, the integrated circuit LB may include back-side patterns MPR which are formed on a backside of the substrate and configure the power distribution network. The back-side patterns MPR may be electrically connected with patterns of the first metal layer M1 through via structures PTC. For example, the integrated circuit LB may include the back-side patterns MPR configuring the power distribution network, and for example, may include a global back-side pattern which provides the global power supply voltage, a first back-side pattern which provides a first power supply voltage, and a second back-side pattern which provides a second power supply voltage.

The first power rails PR1 may be electrically connected with the first back-side pattern, disposed under the first power rails PR1, through a first via structure. The power line PL may be connected with the global back-side pattern, disposed under the power line PL, through a global via structure. In an embodiment, the first via structure and the global via structure may be formed in the switch cell area. Alternatively, in an embodiment, the global via structure may be formed in the switch cell area, and the first via structure may be formed outside the switch cell area.

The second power rails PR2 may be connected with the second back-side pattern, disposed under the second power rails PR2, through a second via structure. The second via structure may be formed outside the switch cell area.

In an embodiment, the global back-side pattern providing the global power supply voltage, the first back-side pattern providing the first power supply voltage, and the second back-side pattern providing the second power supply voltage may extend in the X-axis direction. In an embodiment, the global back-side pattern, the first back-side pattern, and the second back-side pattern may extend in the Y-axis direction. Alternatively, in an embodiment, the global back-side pattern, the first back-side pattern, and the second back-side pattern may be arranged in a mesh form which extends in the X-axis direction and the Y-axis direction.

In an embodiment, widths of the global back-side pattern, the first back-side pattern, and the second back-side pattern may be greater than those of the power line PL, the first power rail PR1, and the second power rail PR2, but are not limited thereto. A width of each of the global back-side pattern, the first back-side pattern, and the second back-side pattern and a width of each of the power line PL, the first power rail PR1, and the second power rail PR2 may be modified.

According to an embodiment, in the integrated circuit LB, the global power supply voltage is applied to the power line PL. The power line PL may be arranged in a row line that provides the second power rail PR2. The second power supply voltage is provided to a logic cell and is applied to the second power rail PR2. Thus, there may be no need to form the power line PL (to which the global power supply voltage is applied) in a region outside row lines where the first power rails PR1 and the second power rails PR2 are arranged. Therefore, only a P-type transistor transferring the global power supply voltage to a power rail may be formed in the switch cell area. Thus, the number of P-type transistors in the switch cell area may increase and an efficient switching operation may be performed.

Also, in the integrated circuit LB according to an embodiment, the global power supply voltage may be provided from the power distribution network, formed based on the back-side pattern MPR, to the power line PL which is a front-side pattern, and thus, a congestion of a routing on the front side of the integrated circuit LB may be solved, thereby enhancing a degree of integration of the integrated circuit LB and reducing the area of the integrated circuit LB.

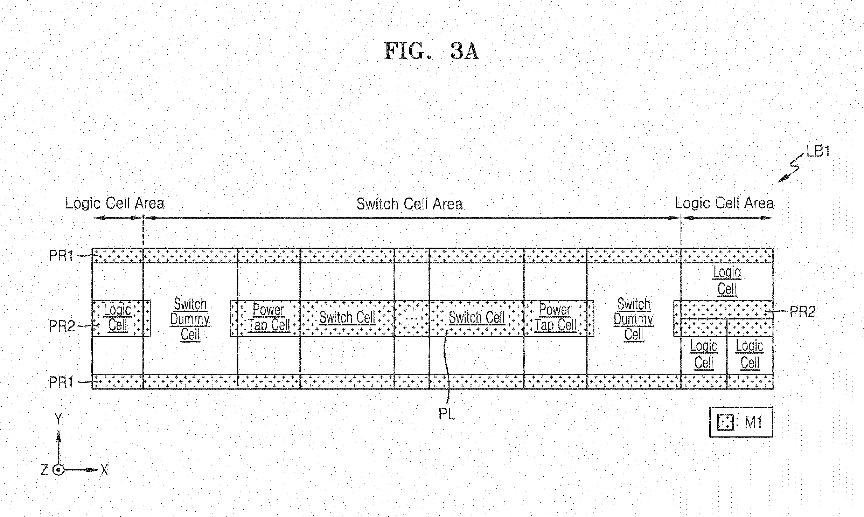

FIGS. 3A to 3C are layout diagrams for describing a logic cell area and a switch cell area of each of integrated circuits LB1 to LB3 according to an embodiment. The integrated circuits LB1 to LB3 of FIGS. 3A to 3C may be embodiments of the integrated circuit LB of FIG. 1.

Referring to FIGS. 3A to 3C, each of the integrated circuits LB1 to LB3 may include a plurality of standard cells. A standard cell may be a unit of a layout included in an integrated circuit, may be designed to perform a predefined function, and may be referred to as a cell. An integrated circuit may include a plurality of various standard cells, and the standard cells may be arranged along and in a plurality of rows. Here, a row direction may be an X-axis direction. The standard cells may be previously designed based on manufacturing technology and may be stored in a standard cell library, and the standard cells stored in the standard cell library may be arranged based on a design rule and may be connected with one another, thereby designing an integrated circuit.

Each of the integrated circuits LB1 to LB3 may include logic cell areas each including a logic cell provided therein. For example, in an embodiment, the logic cell may implement a circuit configuring various basic circuits frequently used in a digital circuit design for electric devices such as a central processing unit (CPU), a graphics processing unit (GPU), and a system on chip (SoC), like an inverter, an AND gate, a NAND gate, an OR gate, an XOR gate, and a NOR gate. Alternatively, for example, in an embodiment, the logic cell may implement another circuit frequently used in a circuit block like a flip-flop and a latch.

Each of the integrated circuits LB1 to LB3 may include a switch cell area disposed between logic cell areas. The switch cell area may include a switch cell, a power tap cell, and a switch dummy cell. The switch cell may include a plurality of P-type transistors connected with the first power rail PR1 and the power line PL to which the global power supply voltage is applied (or receiving the global power supply voltage). The power tap cell may include a global via structure (for example, PTC of FIG. 2) which electrically connects the power line PL with a global back-side pattern (for example, MPR of FIG. 2).

The switch dummy cell may include a brake region which electrically disconnects a logic cell of the logic cell area and the power tap cell or the switch cell of the switch cell area. For example, in an embodiment, the switch dummy cell may include an M1 brake region, which separates the first metal layer M1 so that the second power rail PR2 is not connected with the power line PL, and a front end of line (FEOL) brake region for separating the logic cell from an FEOL pattern of the switch cell. For example, in an embodiment, the FEOL brake region may include a fin cut region which cuts fins provided in an active region.

Referring to FIG. 3A, the power tap cells may be adjacent to the switch dummy cells, and a plurality of switch cells may be disposed closer to the center of the switch cell area than the power tap cells. That is, the power tap cells may be disposed outward from the switch cell area than the plurality of switch cells.

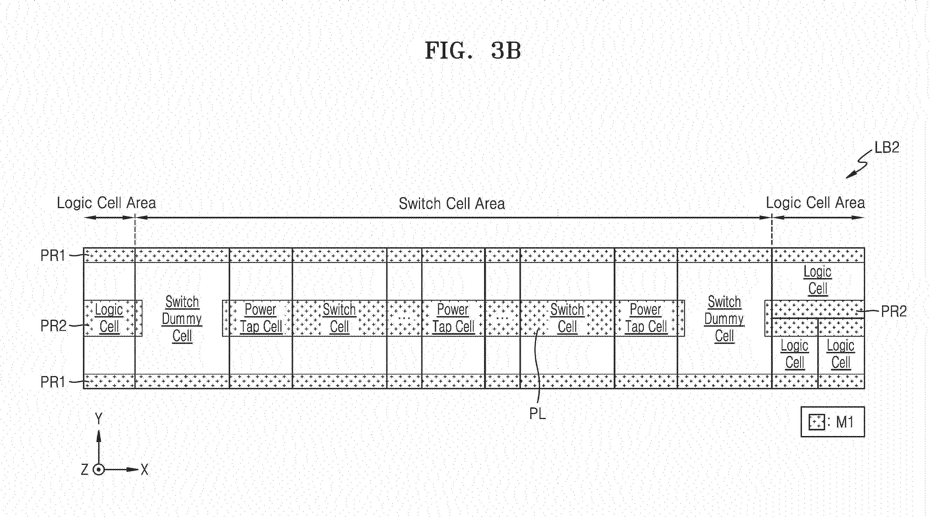

Referring to FIG. 3B, the plurality of power tap cells may be disposed at the center of the switch cell area, and moreover, may be adjacent to the switch dummy cell. The switch cells may be disposed between the power tap cells.

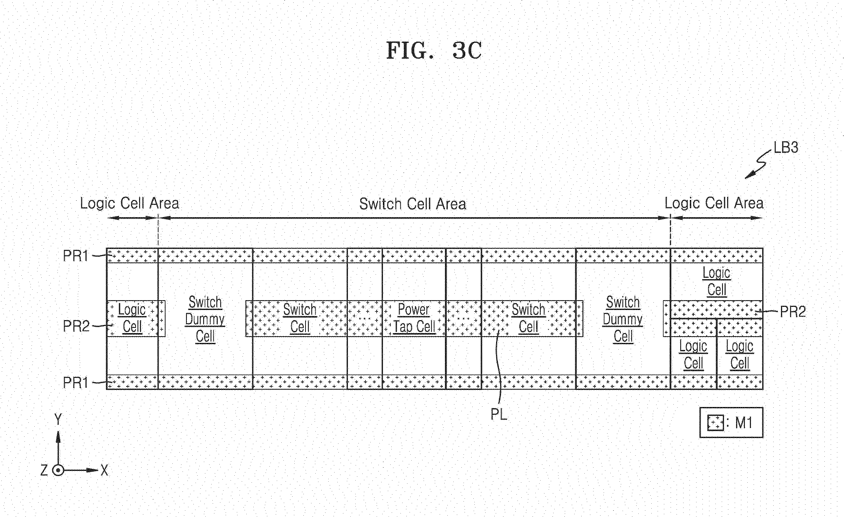

Referring to FIG. 3C, the power tap cell may be disposed at the center of the switch cell area, and a plurality of switch cells may be disposed between the power tap cell and the switch dummy cell.

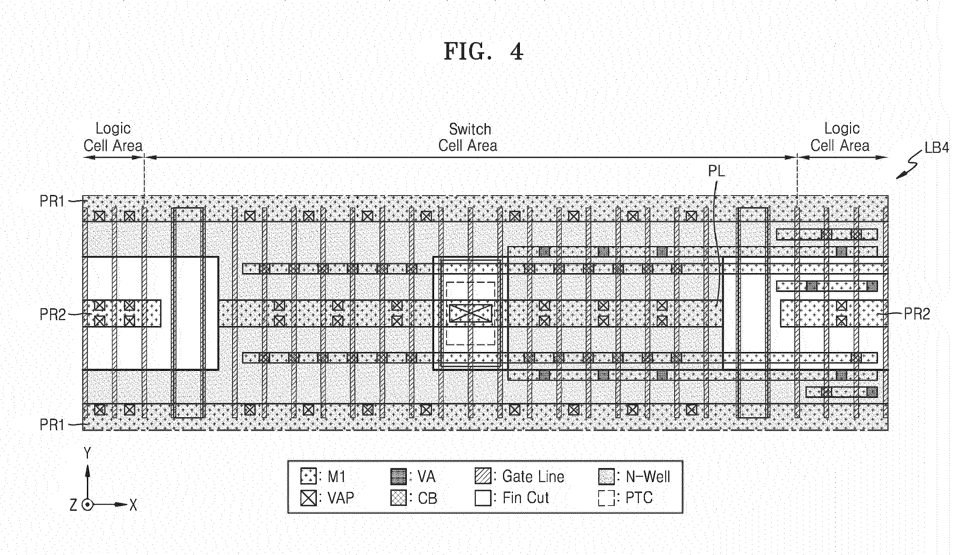

FIG. 4 is a layout diagram for describing a logic cell area and a switch cell area of an integrated circuit LB4 according to an embodiment. For example, in an embodiment, a layout diagram of the integrated circuit LB4 of FIG. 4 may correspond to a layout diagram of the integrated circuit LB3 of FIG. 3C.

Referring to FIG. 4, the integrated circuit LB4 may include a first power rail PR1 extending in the X-axis direction and a second power rail PR2 extending in the X-axis direction, and moreover, may include a power line PL extending in the X-axis direction. The second power rail PR2 may be cut off in a region, which is adjacent to a logic cell area, of a switch cell area, and for example, may be cut off in a region where the switch dummy cell described above with reference to FIGS. 3A to 3C is provided.

Each of the first power rail PR1, the second power rail PR2, and the power line PL formed in a first metal layer M1 may be electrically connected with an active region, disposed thereunder, through a power via VAP. For example, in an embodiment, the first power rail PR1 and the power line PL may be electrically connected with a P-type active region, where a P-type transistor is formed, through the power via VAP, and the second power rail PR2 may be electrically connected with an N-type active region, where an N-type transistor is formed, through the power via VAP. In addition to the power via VAP, a contact connecting the active region with each of the first power rail PR1, the second power rail PR2, and the power line PL may be further provided.

The integrated circuit LB4 may include back-side patterns (for example, MPR of FIG. 2) which are formed on a backside of a substrate. The back-side patterns MPR may be electrically connected with patterns of the first metal layer M1 through via structures PTC. For example, in an embodiment, the power line PL in the switch cell area may be electrically connected with a global back-side pattern, which is the back-side pattern MPR, through the via structure PTC and the power via VAP.

The integrated circuit LB4 may include a plurality of gate lines which are formed to extend in the Y-axis direction and which are apart from one another in the X-axis direction. The gate line may be electrically connected with a wiring pattern of a first metal layer M1 thereon through a gate contact CB. In addition to the gate contact CB, a via connecting the gate line with the wiring pattern of the first metal layer M1 may be further provided.

In an embodiment, each of the gate lines may include a work function metal-containing layer and a gap-fill metal layer. For example, in an embodiment, the work function metal-containing layer may include at least one of titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd), and the gap-fill metal layer may include a W layer or an Al layer. In an embodiment, the gate line may include a stack structure of TiAlC/TiN/W, a stack structure of TiN/TaN/TiAlC/TiN/W, or a stack structure of TiN/TaN/TiN/TiAlC/TiN/W.

Also, the integrated circuit LB4 may include a P-type active region which extends in the X-axis direction and where a P-type transistor is formed and an N-type active region where an N-type transistor is formed. The gate line and the P-type transistor may be provided in the P-type active region, and the gate line and the N-type transistor may be provided in the N-type active region. In an embodiment, the N-type active region may be formed in a P-type substrate doped with P-type impurities and the P-type active region may be formed in an N-type well region N-Well formed in the substrate.

Each of the P-type active region and the N-type active region may be electrically connected with the wiring pattern of the first metal layer M1 thereon through an active via VA. In addition to the active via VA, a contact connecting each of the P-type active region and the N-type active region with the wiring pattern of the first metal layer M1 may be further provided.

A plurality of fins may be arranged to extend in parallel in the X-axis direction, in each of the P-type active region and the N-type active region. The plurality of fins may protrude in a fin shape onto a device insulation layer, in each of the P-type active region and the N-type active region. Accordingly, the plurality of gate lines and each of the P-type active region and the N-type active region may configure a Fin field effect transistor (FET) (FinFET).

In an embodiment, a gate-all-around (GAA) FET may be formed where a nanowire formed on the fin of each of the P-type active region and the N-type active region is surrounded by a gate line, and a vertical GAA FET may be formed where a plurality of nanowires are vertically stacked and surrounded by a gate line. In an embodiment, a nano-sheet may be formed on the fin of each of the P-type active region and the N-type active region is surrounded by a gate line, and a multi bridge channel (MBC) FET may be formed where a plurality of nano-sheets are stacked and surrounded by a gate line.

A fin cut region where fins are cut off may be formed in a region, which is adjacent to a logic cell area, of a switch cell area (for example, in a region where the switch dummy cell described above with reference to FIGS. 3A to 3C is provided). Also, in order to form the via structure PTC passing through the substrate, the fin cut region where the fins are cut off may be formed in a region where the via structure PTC is formed.

An N-type transistor may not be formed and only P-type transistors may be formed in the switch cell area. Because the second power rail PR2 is cut off in the switch cell area, an N-type well region where P-type transistors are formed may be formed to extend between two first power rails PR1 in the switch cell area. That is, an N-type active region where an N-type transistor is formed may not be formed in the switch cell area. On the other hand, all of a P-type transistor and an N-type transistor may be formed in the logic cell area, and thus, the N-type well region N-Well may have a shape of a jog pattern in the switch cell area. The N-type well region N-Well may include a jog pattern where a portion thereof extends in the X-axis direction and the -X-axis direction, in the region, which is adjacent to the logic cell area, of the switch cell area (for example, in the region where the switch dummy cell described above with reference to FIGS. 3A to 3C is provided).

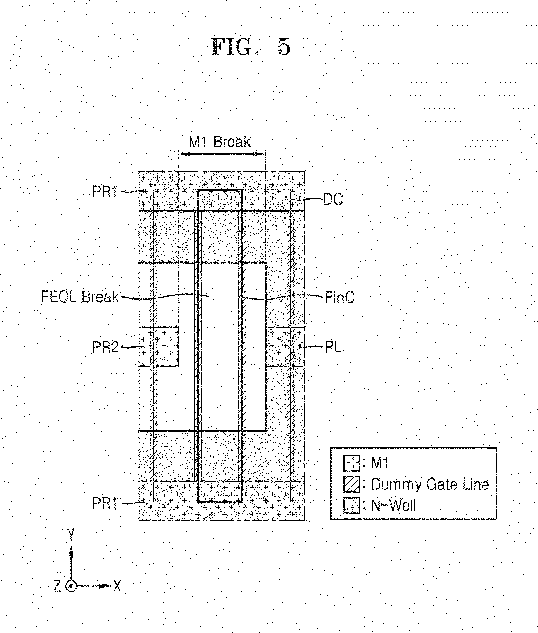

FIG. 5 is a layout diagram for describing a switch dummy cell DC in an integrated circuit according to an embodiment.

Referring to FIG. 5, the switch dummy cell DC may include a plurality of dummy gate lines which are formed to extend in the Y-axis direction and are apart from one another in the X-axis direction. In this case, the dummy gate lines may denote a gate line which is formed but does not perform a function, or may denote a gate line where a position thereof is designated but which is not actually formed. In an embodiment, the switch dummy cell DC may include four or more dummy gate lines, and when an interval between two adjacent dummy gate lines is defined as 1CPP, a width of the switch dummy cell DC in the X-axis direction may be 3CPP or more.

The switch dummy cell DC may include an M1 break region which separates a first metal layer M1 so that a second power rail PR2 is not connected with a power line PL. In an embodiment, a width of the M1 break region in the X-axis direction may be 2CPP or more.

The switch dummy cell DC may include an FEOL break region for isolating a logic cell from an FEOL pattern of a switch cell. For example, in an embodiment, the FEOL break region may include a fin cut region which cuts fins provided in an active region. The FEOL break region may include a diffusion break, and a double diffusion break or a single diffusion break may be formed. The diffusion break may include a silicon-containing insulation layer, such as silicon oxide, silicon nitride, silicon oxynitride, or silicon carbo-nitride, or a combination thereof. For example, in an embodiment, the diffusion break may include fluoride silicate glass (FSG), undoped silicate glass (USG), boro-phosphosilicate glass (BPSG), phosphosilicate glass (PSG), flowable oxide (FOX), plasma enhanced deposition of tetra-ethyl-ortho-silicate (PE-TEOS), or tonen silazene (TOSZ).

An N-type well region N-Well having a jog pattern may be formed in the switch dummy cell DC. That is, a width of the N-type well region N-Well in a second boundary opposite to a first boundary (for example, the second boundary close to the center of the switch cell area) in the switch dummy cell DC may be thicker than a width of the N-type well region N-Well in the first boundary adjacent to the logic cell area in the switch dummy cell DC.

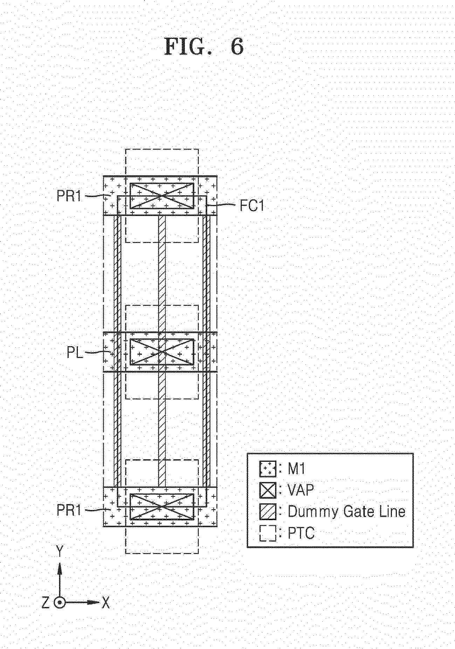

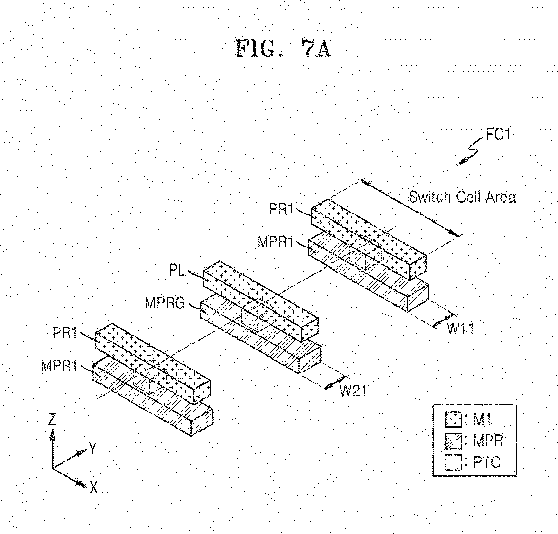

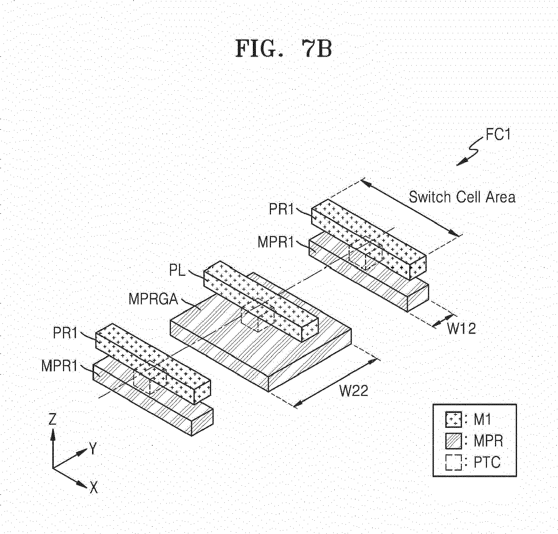

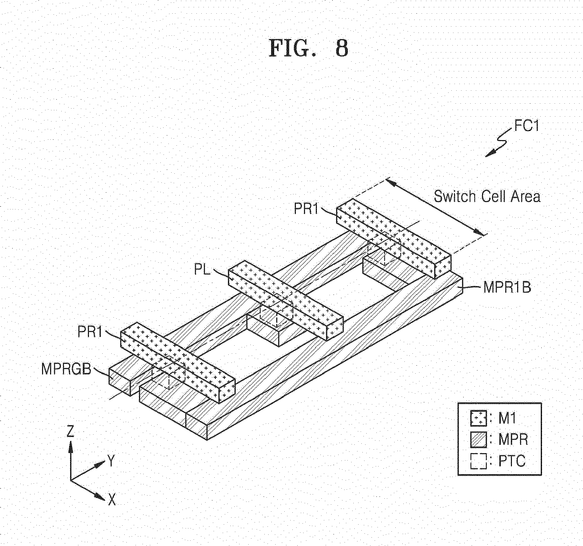

FIG. 6 is a layout diagram for describing a power tap cell FC1 in an integrated circuit according to an embodiment. FIGS. 7A, 7B, and 8 are diagrams for describing a first metal layer M1, a via structure PTC, and a back-side pattern MPR in a switch cell area including a power tap cell FC1. In FIGS. 7A, 7B, and 8, a power via VAP is omitted, but the power via VAP may be disposed between the first metal layer M1 and the via structure PTC.

Referring to FIGS. 6, 7A, 7B, and 8, the power tap cell FC1 may include a plurality of dummy gate lines which are formed to extend in the Y-axis direction and are apart from one another in the X-axis direction. In an embodiment, the power tap cell FC1 may include three or more dummy gate lines, and a width of the power tap cell FC1 in the X-axis direction may be 2CPP or more.

An integrated circuit (including the power tap cell FC 1) may include back-side patterns MPR which are formed on a backside of a substrate and configure a power distribution network. The back-side patterns MPR may be electrically connected with patterns of the first metal layer M1 through via structures PTC. For example, in an embodiment, the integrated circuit (including the power tap cell FC1) may include global back-side patterns MPRG, MPRGA, and MPRGB, which provide a global power supply voltage, and first back-side patterns MPR1 and MPR1B, which provide a first power supply voltage.

The power tap cell FC1 may include a via structure PTC, which electrically connects a plurality of first power rails PR1 with the first back-side patterns MPR1 and MPR1B, and a via structure PTC, which electrically connects the power line PL with the global back-side patterns MPRG, MPRGA, and MPRGB. The via structure PTC, which electrically connects a plurality of first power rails PR1 with the first back-side patterns MPR1 and MPR1B, may be referred to as a first via structure, and the via structure, PTC which electrically connects the power line PL with the global back-side patterns MPRG, MPRGA, and MPRGB, may be referred to as a global via structure.

In an embodiment, in the power tap cell FC1, the global via structure and the first via structures may be aligned with one another in the Y-axis direction. In an embodiment, the global via structure and the first via structures may be disposed on a line where a dummy gate line is disposed.

Referring to FIG. 7A, a global back-side pattern MPRG and a first back-side pattern MPR1 may be provided as a back-side pattern MPR extending in the X-axis direction. Also, a second back-side pattern, which is electrically connected with a second power rail (for example, PR2 of FIG. 2) and provides a second power supply voltage, may also extend in the X-axis direction. In an embodiment, a width W11 of the first back-side pattern MPR1, a width W21 of the global back-side pattern MPRG, and a width of the second back-side pattern may be equal to one another.

Referring to FIG. 7B, a width of each of a first back-side pattern MPR1, a global back-side pattern MPRGA, and a second back-side pattern may be variously adjusted. At least one of the first back-side pattern MPR1, the global back-side pattern MPRGA, and the second back-side pattern may have a width which differs from that of the other pattern. For example, in an embodiment, a width W22 of the global back-side pattern MPRGA may be greater than a width W12 of the first back-side pattern MPR1.

In an embodiment, two of the first back-side pattern MPR1, the global back-side pattern MPRGA, and the second back-side pattern may have the same width, and the other pattern may have a different width. For example, in an embodiment, a width W22 of the global back-side pattern MPRGA may be greater than a width W12 of the first back-side pattern MPR1 and a width of the second back-side pattern, the width W12 of the first back-side pattern MPR1 may be greater than the width W22 of the global back-side pattern MPRGA and the width of the second back-side pattern, or the width of the second back-side pattern may be greater than the width W12 of the first back-side pattern MPR1 and the width W22 of the global back-side pattern MPRGA.

In an embodiment, the first back-side pattern MPR1, the global back-side pattern MPRGA, and the second back-side pattern may have different widths. For example, in an embodiment, the width W22 of the global back-side pattern MPRGA may be greater than the width W12 of the first back-side pattern MPR1, and the width W12 of the first back-side pattern MPR1 may be greater than the width of the second back-side pattern. Alternatively, for example, in an embodiment, the width W22 of the global back-side pattern MPRGA may be greater than the width of the second back-side pattern, and the width of the second back-side pattern may be greater than the width W12 of the first back-side pattern MPR1.

For example, in an embodiment, the width W12 of the first back-side pattern MPR1 may be greater than the width W22 of the global back-side pattern MPRGA, and the width W22 of the global back-side pattern MPRGA may be greater than the width of the second back-side pattern. Alternatively, for example, in an embodiment, the width W12 of the first back-side pattern MPR1 may be greater than the width of the second back-side pattern, and the width of the second back-side pattern may be greater than the width W22 of the global back-side pattern MPRGA.

For example, in an embodiment, the width of the second back-side pattern may be greater than the width W22 of the global back-side pattern MPRGA, and the width W22 of the global back-side pattern MPRGA may be greater than the width W12 of the first back-side pattern MPR1. Alternatively, for example, in an embodiment, the width of the second back-side pattern may be greater than the width W12 of the first back-side pattern MPR1, and the width W12 of the first back-side pattern MPR1 may be greater than the width W22 of the global back-side pattern MPRGA.

Referring to FIG. 8, a global back-side pattern MPRGB and a first back-side pattern MPR1B may be provided as a back-side pattern MPR extending in the Y-axis direction. Also, a second back-side pattern, which is electrically connected with a second power rail (for example, PR2 of FIG. 2) and provides a second power supply voltage, may also extend in the Y-axis direction. The first back-side pattern MPR1B and the global back-side pattern MPRGB may each include a protrusion portion which contacts a via structure PTC. In an embodiment, widths of a first back-side pattern MPR1B, a global back-side pattern MPRGB, and a second back-side pattern may be equal to one another, or in an embodiment, at least one of the first back-side pattern MPR1B, the global back-side pattern MPRGB, and the second back-side pattern may have a width which differs from that of the other pattern.

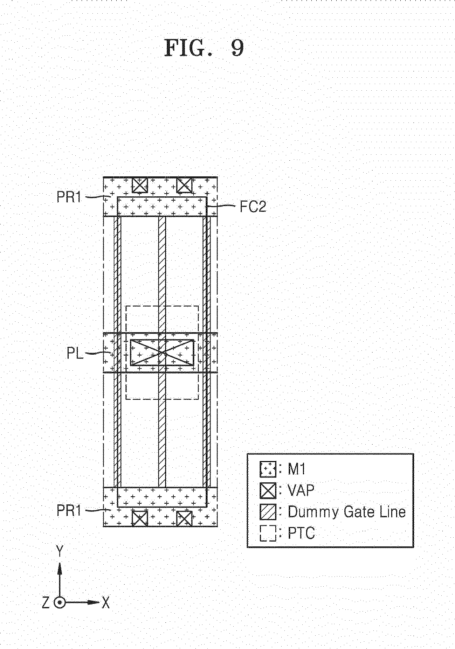

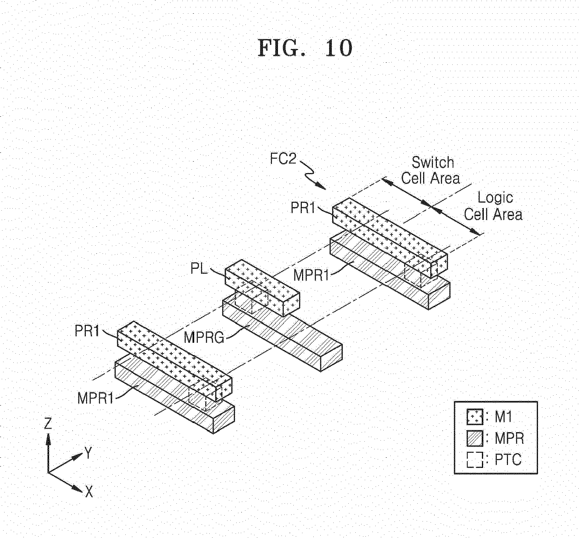

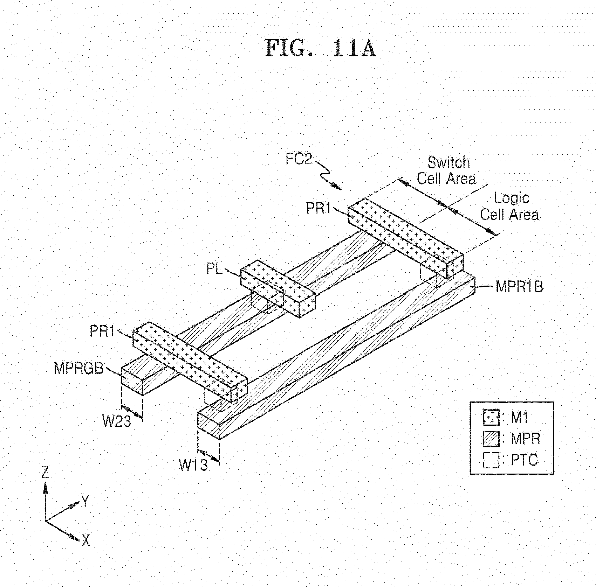

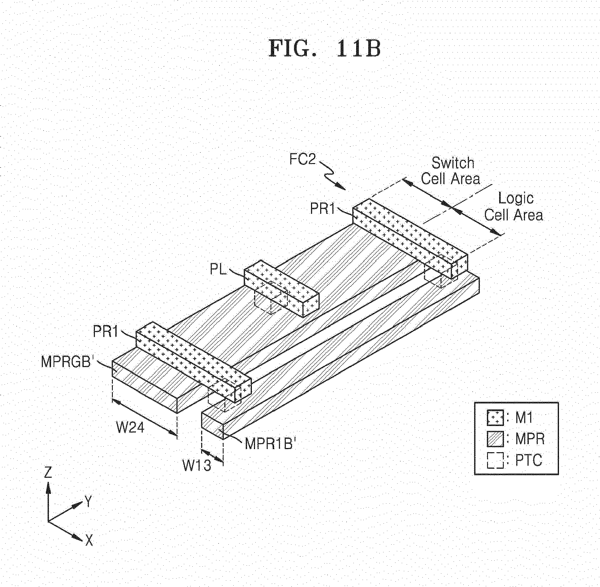

FIG. 9 is a layout diagram for describing a power tap cell FC2 in an integrated circuit according to an embodiment. FIGS. 10, 11A, and 11B are diagrams for describing a first metal layer M1, a via structure PTC, and a back-side pattern MPR in a switch cell area and a logic cell area each including the power tap cell FC2. In FIGS. 10, 11A, and 11B, a power via VAP is omitted, but the power via VAP may be disposed between the first metal layer M1 and the via structure PTC.

Referring to FIGS. 9, 10, 11A, and 11B, the power tap cell FC2 may include a plurality of dummy gate lines which are formed to extend in the Y-axis direction and are apart from one another in the X-axis direction. In an embodiment, the power tap cell FC2 may include three or more dummy gate lines, and a width of the power tap cell FC2 in the X-axis direction may be 2CPP or more.

An integrated circuit (including the power tap cell FC2) may include back-side patterns MPR which are formed on a backside of a substrate and configure a power distribution network. The back-side patterns MPR may be electrically connected with patterns of the first metal layer M1 through via structures PTC.

For example, in an embodiment, the integrated circuit including the power tap cell FC2 may include global back-side patterns MPRG, MPRGB, and MPRGB' which provide a global power supply voltage, first back-side patterns MPR1, MPR1B, and MPR1B' which provide a first power supply voltage, and a second back-side pattern which provides a second power supply voltage. Alternatively, for example, the integrated circuit including the power tap cell FC2 may include only the global back-side patterns MPRG, MPRGB, and MPRGB' which provide the global power supply voltage, or a first power rail PR1 and a second power rail (for example, PR2 of FIG. 2) each formed in the first metal layer M1 may be respectively supplied with the first power supply voltage and the second power supply voltage through the power distribution network (i.e., a front-side pattern) which is formed in an upper metal layer than the first metal layer M1.

The power tap cell FC2 may include a via structure PTC, which electrically connects the power line PL with the global back-side patterns MPRG, MPRGB, and MPRGB'. On the other hand, the power tap cell FC2 may include a via structure PTC, which electrically connects a plurality of first power rails PR1 with the first back-side patterns MPR1, MPR1B, and MPR1B'. The via structure PTC electrically connecting the plurality of first power rails PR1 with the first back-side patterns MPR1, MPR1B, and MPR1B' may be referred to as a first via structure, and the via structure PTC electrically connecting the power line PL with the global back-side patterns MPRG, MPRGB, and MPRGB' may be referred to as a global via structure.

In an embodiment, in the integrated circuit including the power tap cell FC2, the global via structure and the first via structures may be misaligned in the Y-axis direction. That is, in the integrated circuit including the power tap cell FC2, the global via structure and the first via structures may be arranged to be staggered with each other in the Y-axis direction. In an embodiment, in the integrated circuit including the power tap cell FC2, the global via structure may be in a switch cell area, and the first via structure and the second via structure connecting the second back-side pattern with the second power rail PR2 may be in a logic cell area.

Referring to FIG. 10, a global back-side pattern MPRG and a first back-side pattern MPR1 may be provided as a back-side pattern MPR extending in the X-axis direction. Also, a second back-side pattern, which is electrically connected with a second power rail (for example, PR2 of FIG. 2) and provides a second power supply voltage, may also extend in the X-axis direction. In an embodiment, widths of a first back-side pattern MPR1, a global back-side pattern MPRG, and a second back-side pattern may be equal to one another, or in an embodiment, at least one of the first back-side pattern MPR1, the global back-side pattern MPRG, and the second back-side pattern may have a width which differs from that of the other pattern.

Referring to FIG. 11A, a global back-side pattern MPRGB and a first back-side pattern MPR1B may be provided as a back-side pattern MPR extending in the Y-axis direction. Also, a second back-side pattern, which is electrically connected with a second power rail PR2 and provides a second power supply voltage, may also extend in the Y-axis direction. In an embodiment, a width W23 of the first back-side pattern MPR1B, a width W23 of the global back-side pattern MPRGB, and a width of the second back-side pattern may be equal to one another.

Referring to FIG. 11B, a width of each of a first back-side pattern MPR1B', a global back-side pattern MPRGB', and a second back-side pattern may be variously adjusted. At least one of the first back-side pattern MPR1B', the global back-side pattern MPRGB', and the second back-side pattern may have a width which differs from that of the other pattern. For example, in an embodiment, a width W24 of the global back-side pattern MPRGB' may be greater than a width W14 of the first back-side pattern MPR1B'.

In an embodiment, two of the first back-side pattern MPR1B', the global back-side pattern MPRGB', and the second back-side pattern may have the same width and the other pattern may have a different width. For example, in an embodiment, the width W24 of the global back-side pattern MPRGB' may be greater than the width W14 of the first back-side pattern MPR1B' and the width of the second back-side pattern, the width W14 of the first back-side pattern MPR1B' may be greater than the width W24 of the global back-side pattern MPRGB' and the width of the second back-side pattern, or the width of the second back-side pattern may be greater than the width W14 of the first back-side pattern MPR1B' and the width W24 of the global back-side pattern MPRGB'.

In an embodiment, the first back-side pattern MPR1B', the global back-side pattern MPRGB', and the second back-side pattern may have different widths. For example, in an embodiment, the width W24 of the global back-side pattern MPRGB' may be greater than the width W14 of the first back-side pattern MPR1B', and the width W14 of the first back-side pattern MPR1B' may be greater than the width of the second back-side pattern. Alternatively, for example, the width W24 of the global back-side pattern MPRGB' may be greater than the width of the second back-side pattern, and the width of the second back-side pattern may be greater than the width W14 of the first back-side pattern MPR1B'.

For example, in an embodiment, the width W14 of the first back-side pattern MPR1B' may be greater than the width W24 of the global back-side pattern MPRGB', and the width W24 of the global back-side pattern MPRGB' may be greater than the width of the second back-side pattern. Alternatively, for example, the width W14 of the first back-side pattern MPR1B' may be greater than the width of the second back-side pattern, and the width of the second back-side pattern may be greater than the width W24 of the global back-side pattern MPRGB'.

For example, in an embodiment, the width of the second back-side pattern may be greater than the width W24 of the global back-side pattern MPRGB', and the width W24 of the global back-side pattern MPRGB' may be greater than the width W14 of the first back-side pattern MPR1B'. Alternatively, for example, the width of the second back-side pattern may be greater than the width W14 of the first back-side pattern MPR1B', and the width W14 of the first back-side pattern MPR1B' may be greater than the width W24 of the global back-side pattern MPRGB' .

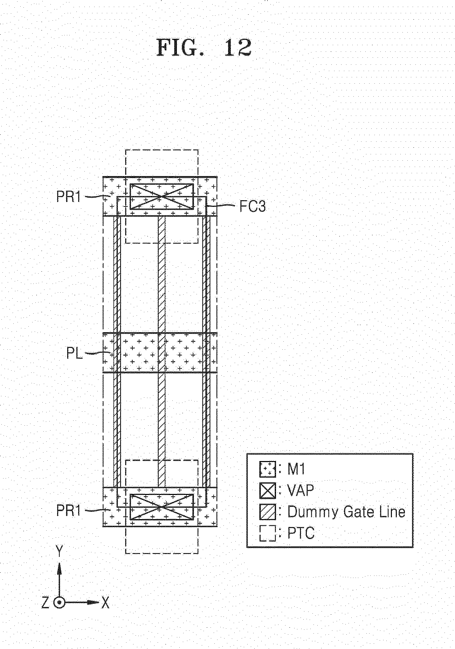

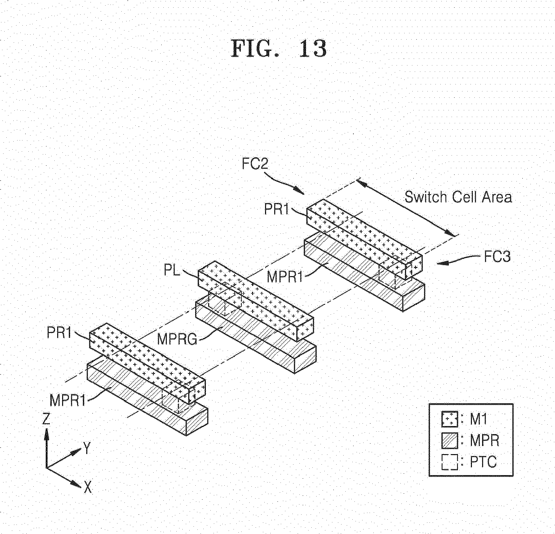

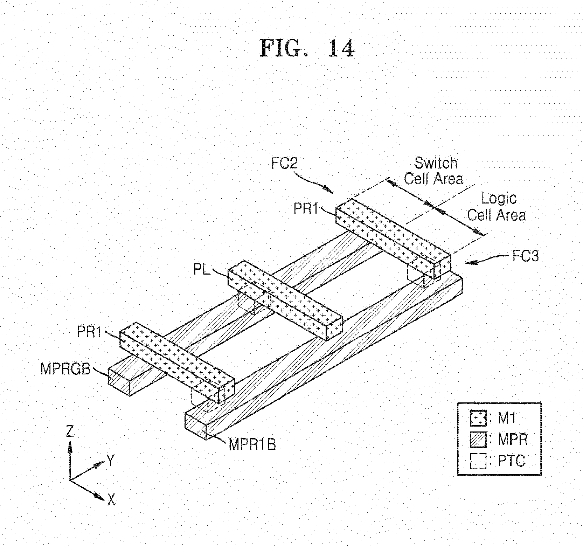

FIG. 12 is a layout diagram for describing a power tap cell FC3 in an integrated circuit according to an embodiment. FIGS. 13 and 14 are diagrams for describing a first metal layer M1, a via structure PTC, and a back-side pattern MPR in a switch cell area including a power tap cell FC2 and a power tap cell FC3. In FIGS. 13 and 14, a power via VAP is omitted, but the power via VAP may be disposed between the first metal layer M1 and the via structure PTC.

Referring to FIGS. 12 to 14, the power tap cell FC3 may include a plurality of dummy gate lines which are formed to extend in the Y-axis direction and are apart from one another in the X-axis direction. In an embodiment, the power tap cell FC3 may include three or more dummy gate lines, and a width of the power tap cell FC2 in the X-axis direction may be 2CPP or more.

The power tap cell FC3 may include a via structure PTC (i.e., a first via structure) which electrically connects a plurality of first power rails PR1 with first back-side patterns MPR1 and MPR1B. On the other hand, the power tap cell FC3 may not include a via structure PTC (i.e., a global via structure) which electrically connects a power line PL with global back-side patterns MPRG and MPRGB.

In an embodiment, in the integrated circuit including the power tap cell FC3, the global via structure and the first via structures may be misaligned in the Y-axis direction. That is, in the integrated circuit including the power tap cell FC3, the global via structure and the first via structures may be arranged to be staggered with each other in the Y-axis direction.

Referring to FIG. 13, a global back-side pattern MPRG and a first back-side pattern MPR1 may be provided as a back-side pattern MPR extending in the X-axis direction. Also, a second back-side pattern, which is electrically connected with a second power rail (for example, PR2 of FIG. 2) and provides a second power supply voltage, may also extend in the X-axis direction.

Referring to FIG. 14, a global back-side pattern MPRGB and a first back-side pattern MPR1B may be provided as a back-side pattern MPR extending in the Y-axis direction. Also, a second back-side pattern, which is electrically connected with a second power rail (for example, PR2 of FIG. 2) and provides a second power supply voltage, may also extend in the Y-axis direction.

Referring to FIGS. 13 and 14, in an embodiment, widths of the first back-side patterns MPRG and MPR1B, the global back-side patterns MPR1 and MPRGB, and the second global pattern may be equal to one another. Alternatively, in an embodiment, at least one of the first back-side patterns MPRG and MPR1B, the global back-side patterns MPR1 and MPRGB, and the second the second back-side pattern may have a width which differs from that of the other pattern. A width of each of the first back-side patterns MPRG and MPR1B, the global back-side patterns MPR1 and MPRGB, and the second back-side pattern may be variously adjusted.

FIG. 15 is a layout diagram for describing an integrated circuit LB' according to an embodiment.

Referring to FIG. 15, the integrated circuit LB' may include standard cells which are arranged in a series of rows extending in the X-axis direction. Rows may be defined, and a plurality of first power rails (for example, PR1 of FIG. 1) and a plurality of second power rails (for example, PR2 of FIG. 1) may be in a plurality of row lines which are boundaries of the rows. Also, a power line (for example, PL of FIG. 1) may be in a row line where two second power rails PR2 adjacent to each other in the X-axis direction among the plurality of second power rails PR2 are cut off.

In an embodiment, a plurality of switch cell areas SCA including the power line PL may be arranged continuously in the Y-axis direction (i.e., arranged along a column line). In an embodiment, in the integrated circuit LB', the plurality of switch cell areas SCA may be arranged continuously up to an end thereof in the -Y-axis direction from an end thereof in the Y-axis direction. Alternatively, in an embodiment, in the integrated circuit LB', the plurality of switch cell areas SCA may be arranged continuously in the Y-axis direction in only a partial region between the end thereof in the -Y-axis direction from the end thereof in the Y-axis direction.

The switch cell, the switch dummy cell, and the power tap cell each described above with reference to FIGS. 3A to 3C may be in each of the plurality of switch cell areas SCA. Only a P-type transistor transferring a global power supply voltage to a first power rail PR1 may be formed in the switch cell area SCA, and thus, a number of P-type transistors with respect to the same area may be formed and efficient switching may be performed.

Unlike the illustration of FIG. 15, a plurality of switch cell areas SCA including the power line PL may be arranged continuously in the X-axis direction (i.e., arranged along a row line). In an embodiment, in the integrated circuit LB', a plurality of switch cell areas SCA may be arranged continuously up to an end thereof in the -X-axis direction from an end thereof in the X-axis direction, and in this case, a switch cell and a power tap cell may be in each of the plurality of switch cell areas SCA and a switch dummy cell, which is an element for electrically disconnecting the switch cell and the power tap cell from a logic cell, may be omitted. Alternatively, in an embodiment, in the integrated circuit LB', the plurality of switch cell areas SCA may be arranged continuously in the X-axis direction in only a partial region between the end thereof in the -X-axis direction from the end thereof in the X-axis direction.

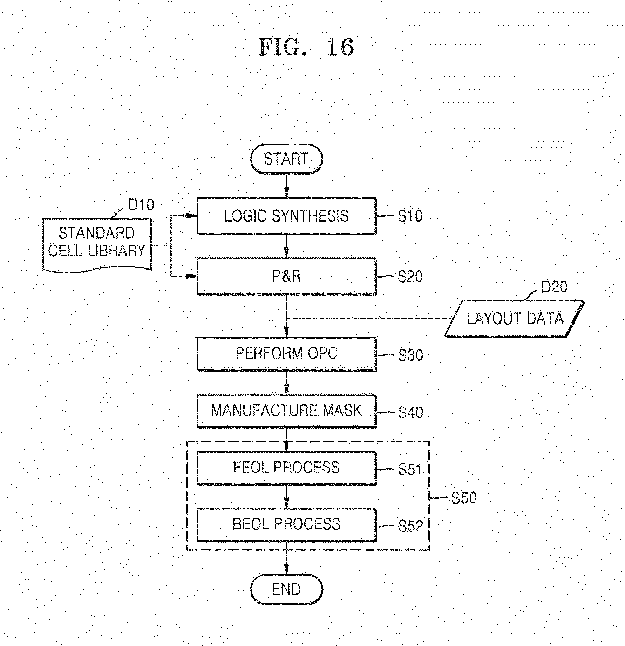

FIG. 16 is a flowchart illustrating a method of manufacturing an integrated circuit, according to an embodiment. In detail, the flowchart of FIG. 16 illustrates a method of manufacturing the integrated circuit (for example, LB1 to LB3 and LB' of FIGS. 1, 3A to 3C, and 15) described above.

A standard cell library (or a cell library) D10 may include information about standard cells (for example, function information, characteristic information, and layout information), information about a switch cell, a power tap cell, and a switch dummy cell each in a switch cell area, and information about logic cells in a logic cell area.

In operation S10, a logic synthesis operation of generating a netlist from register transfer level (RTL) data. For example, in an embodiment, a semiconductor design tool (for example, a logic synthesis tool) may perform logic synthesis with reference to the standard cell library D10 from RTL data written in hardware description language (HDL) such as Verilog and VHSIC hardware description language (VHDL) and may thus generate a bit stream or a netlist. The standard cell library D10 may include information about performance of the standard cells, and the standard cells may be included in an integrated circuit IC with reference to the information in a logic synthesis operation.

In operation S20, a place & routing (P&R) operation of generating layout data D20 from the netlist may be performed. In the P&R operation S20, an operation of placing the standard cells, an operation of generating interconnections, and an operation of generating the layout data D20 may be performed.

For example, in an embodiment, the semiconductor design tool (for example, the P&R tool) may place a plurality of standard cells with reference to the standard cell library D10 from the netlist. For example, in an embodiment, the semiconductor design tool may place a layout of the switch cell, the power tap cell, and the switch dummy cell each defined by the netlist, with reference to the standard cell library D10.

In an embodiment, in performing the P&R operation (operation S20), switch dummy cells may be placed, and then, logic cells may be placed. For example, in an embodiment, in performing the P&R operation, logic cells may be placed after the switch cell, the power tap cell, and the switch dummy cell are placed. Therefore, the standard cells may be efficiently placed while electrically disconnecting the logic cells, in the logic cell area, from the switch cell and the power tap cell each in the switch cell area.

In the operation of generating the interconnections, the interconnection may electrically connect an output pin of a standard cell with an input pin of the standard cell, and for example, may include at least one via and at least one conductive pattern. The layout data D20 may have, for example, a format such as GDSII and may include geometric information about the standard cells and the interconnections.

In operation S30, optical proximity correction (OPC) may be performed. The OPC may correct distortion such as refraction caused by a characteristic of light in a photolithography process included in a semiconductor process of manufacturing the integrated circuit IC and may thus denote an operation of forming a pattern having a desired shape, and moreover, the OPC may be applied to the layout data D20 to determine a pattern of a mask. In an embodiment, a layout of the integrated circuit may be restrictively modified in operation S30, and an operation of restrictively modifying the integrated circuit in operation S30 may be post-processing for optimizing a structure of the integrated circuit and may be referred to as design polishing.

In operation S40, an operation of manufacturing a mask may be performed. For example, in an embodiment, as the OPC is applied to the layout data D20, patterns of a mask may be defined for forming patterns formed in a plurality of layers, and at least one mask (or photomask) for forming patterns of each of the plurality of layers may be manufactured.

In operation S50, an operation of manufacturing the integrated circuit may be performed. For example, in an embodiment, the integrated circuit may be manufactured by patterning the plurality of layers by using at least one mask which is manufactured in operation S40. As illustrated in FIG. 16, operation S50 may include operations S51 and S52. In operation S51, an FEOL process may be performed. The FEOL may denote an operation of forming individual elements (for example, a transistor, a capacitor, and a resistor) on a substrate in a process of manufacturing the integrated circuit. For example, in an embodiment, the FEOL may include an operation of planarizing and cleaning a wafer, an operation of forming a trench, an operation of forming a well, an operation of forming a gate line, and an operation of forming a source and a drain. In operation S52, a back end of line (BEOL) process may be performed. The BEOL process may denote an operation of connecting individual elements (for example, a transistor, a capacitor, and a resistor) with one another in the process of manufacturing the integrated circuit. For example, in an embodiment, the BEOL process may include an operation of performing silicidation of a gate region, a source region, and a drain region, an operation of adding a dielectric, an operation of performing planarization, an operation of forming a hole, an operation of adding a metal layer, an operation of forming a via, and an operation of forming a passivation layer. Subsequently, the integrated circuit may be packaged in a semiconductor package and may be used as parts of various applications. As described above, based on a good characteristic of a clock gating cell, an integrated circuit may have high performance and efficiency, and thus, the performance and efficiency of an application including the integrated circuit may be improved.

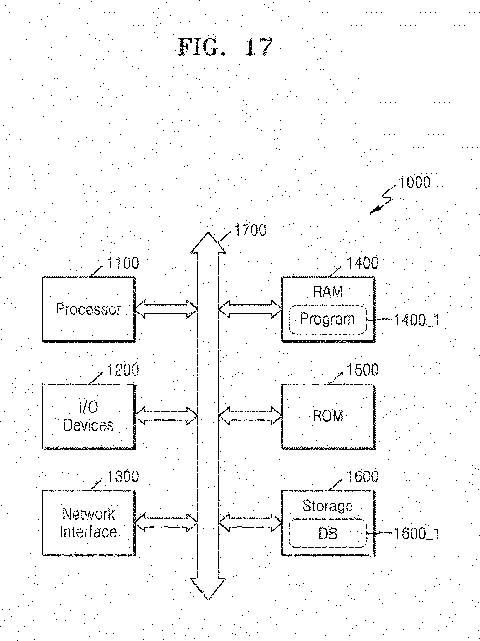

FIG. 17 is a block diagram illustrating a computing system 1000 including a memory storing a program, according to an embodiment. According to an embodiment, at least some of operations included in a method (for example, the method of FIG. 16) of manufacturing an integrated circuit may be performed in the computing system 1000. The computing system 1000 may include a stationary computing system such as a desktop computer, a workstation, or a server, or may include a portable computing system such as a lap-top computer.

Referring to FIG. 17, the computing system 1000 may include a processor 1100, input/output (I/O) devices 1200, a network interface 1300, random access memory (RAM) 1400, read only memory (ROM) 1500, and a storage 1600. The processor 1100, the I/O devices 1200, the network interface 1300, the RAM 1400, the ROM 1500, and the storage 1600 may be connected with a bus 1700 and may communicate with one another through the bus 1700.

The processor 1100 may be referred to as a processing unit, and for example, may include at least one core for executing an arbitrary instruction set (for example, Intel Architecture-32 (IA-32), 64 bit extension IA-32, x86-64, PowerPC, Sparc, MIPS, ARM, IA-64, etc.), like a microprocessor, an application processor (AP), a digital signal processor (DSP), and a graphics processing unit (GPU). For example, in an embodiment, the processor 1100 may access a memory (i.e., the RAM 1400 or the ROM 1500) through the bus 1700 and may execute instructions stored in the RAM 1400 or the ROM 1500.

The RAM 1400 may store a program 1420 for manufacturing an integrated circuit according to an embodiment or at least a portion thereof, and the program 1420 may allow the processor 1100 to perform at least some of operations included in the method (for example, the method of FIG. 16) of manufacturing the integrated circuit. That is, the program 1420 may include a plurality of instructions executable by the processor 1100, and the plurality of instructions included in the program 1420 may allow the processor 1100 to perform at least some of the operations included in the flowchart described above with reference to FIG. 16.

The storage 1600 may maintain data stored therein even when power supplied to the computing system 1000 is cut off. For example, in an embodiment, the storage 1600 may include a non-volatile memory device, or may include a storage medium such as a magnetic tape, an optical disk, and a magnetic disk. Also, the storage 1600 may be attached or detached on or from the computing system 1000. The storage 1600 may store the program 1420 according to an embodiment, and the program 1420 or at least a portion thereof may be loaded from the storage 1600 into the RAM 1400 before the program 1420 is executed by the processor 1100. Alternatively, the storage 1600 may store a file written in a program language, and the program 1420 generated from the file by a compiler or at least a portion thereof may be loaded into the RAM 1400. Also, as illustrated in FIG. 17, the storage 1600 may store a database (DB) 1620, and the DB 1620 may include information (for example, the standard cell library D10 of FIG. 16) needed for designing an integrated circuit.

The storage 1600 may store data which is to be processed by the processor 1100 or data obtained through processing by the processor 1100. That is, the processor 1100 may process the data stored in the storage 1600 to generate data, based on the program 1420, and may store the generated data in the storage 1600. For example, in an embodiment, the storage 1600 may store the RTL data, the netlist, and/or the layout data D20 each described above with reference to FIG. 16.

The I/O devices 1200 may include an input device such as a keyboard or a pointing device and may include an output device such as a display device or a printer. For example, in an embodiment, a user may trigger execution of the program 1420 through the I/O devices 1200 by using the processor 1100, input the RTL data and/or the netlist each described above with reference to FIG. 16, and check the layout data D20 of FIG. 16.

The network interface 1300 may provide an access to a network outside the computing system 1000. For example, in an embodiment, the network may include a plurality of computing systems and communication links, and the communication links may include wired links, optical links, wireless links, or links of arbitrary other type.

Hereinabove, example embodiments have been described in the drawings and the specification. Embodiments have been described by using the terms described herein, but this has been merely used for describing the inventive concept and has not been used for limiting a meaning or limiting the scope of the inventive concept defined in the following claims. Therefore, it may be understood by those of ordinary skill in the art that various modifications and other equivalent embodiments may be implemented from the disclosure. Accordingly, the spirit and scope of the disclosure may be defined based on the spirit and scope of the following claims.

While example embodiments of the disclosure have been particularly shown and described, it will be understood that various changes in form and details may be made therein without departing from the scope of the following claims.

## Claims

1. An integrated circuit comprising:
a plurality of first power rails extending in a first horizontal direction and configured to provide a first power supply voltage that is applied thereto;
a plurality of second power rails extending in the first horizontal direction and configured to provide a second power supply voltage that is applied thereto; and
a power line in a switch cell area and extending in the first horizontal direction the power line being configured to provide a global power supply voltage that is applied thereto,
wherein the plurality of first power rails and the plurality of second power rails are alternately arranged in a second horizontal direction vertical to the first horizontal direction,
wherein the plurality of first power rails, the plurality of second power rails, and the power line form a front-side pattern on a same layer, and
wherein the power line is provided between two second power rails adjacent to each other in the first horizontal direction, among the plurality of second power rails.

2. The integrated circuit of claim 1, wherein the switch cell area is adjacent to a logic cell area in which logic cells are provided, and
wherein the switch cell area comprises a break region electrically separating the switch cell area from the logic cell area.

3. The integrated circuit of claim 1 or 2, further comprising:
a global back-side pattern configured to provide the global power supply voltage; and
a global via structure electrically connecting the power line to the global back-side pattern.

4. The integrated circuit of claim 3, further comprising:
a first back-side pattern configured to provide the first power supply voltage;
a second back-side pattern configured to provide the second power supply voltage;
a first via structure electrically connecting the plurality of first power rails to the first back-side pattern; and
a second via structure electrically connecting the plurality of second power rails to the second back-side pattern.

5. The integrated circuit of claim 4, wherein the global back-side pattern, the first back-side pattern, and the second back-side pattern extend in the first horizontal direction.

6. The integrated circuit of claim 4, wherein the global back-side pattern, the first back-side pattern, and the second back-side pattern extend in the second horizontal direction.

7. The integrated circuit of claim 4, wherein the global via structure and the first via structure are aligned in the second horizontal direction.

8. The integrated circuit of claim 4, wherein the global via structure and the first via structure are misaligned in the second horizontal direction.

9. An integrated circuit comprising:
a plurality of logic cell areas, each of the plurality of logic cell areas comprising a logic cell;
a switch cell area between the plurality of logic cell areas;
a plurality of first power rails extending in a first horizontal direction and configured to provide a first power supply voltage that is applied thereto; and
a plurality of second power rails extending in the first horizontal direction and configured to provide a second power supply voltage that is applied thereto,
wherein the switch cell area comprises:
a switch cell comprising:
a power line configured to provide a global power supply voltage that is applied thereto, and
a plurality of P-type transistors connected to the plurality of first power rails;
a power tap cell comprising a global via structure electrically connecting the power line to a back-side pattern; and
a switch dummy cell electrically separating the logic cell from the switch cell, and
wherein two second power rails adjacent to each other in the first horizontal direction, among the plurality of second power rails, are cut off in the switch cell area.

10. The integrated circuit of claim 9, wherein the switch dummy cell is adjacent to a logic cell area,
wherein the power tap cell is adjacent to the switch dummy cell, and
wherein the switch cell is adjacent to the power tap cell.

11. The integrated circuit of claim 9, wherein the switch dummy cell is adjacent to a logic cell area, and
wherein the power tap cell is provided at a center portion of the switch cell area.

12. The integrated circuit of any one of claims 9 to 11, wherein the switch dummy cell comprises:
a plurality of dummy gate lines extending in a second horizontal direction perpendicular to the first horizontal direction;
an N-type well region comprising a jog pattern; and
a break region electrically separating the power line from a corresponding second power rail adjacent to the power line.

13. The integrated circuit of any one of claims 9 to 12, further comprising:
a global back-side pattern electrically connected to the power line and configured to provide the global power supply voltage;
a first back-side pattern electrically connected to the plurality of first power rails and configured to provide the first power supply voltage; and
a second back-side pattern electrically connected to the plurality of second power rails and configured to provide the second power supply voltage.

14. The integrated circuit of claim 13, wherein the power tap cell comprises a plurality of first via structures electrically connecting the plurality of first power rails to the first back-side pattern.

15. An integrated circuit compri sing:
a plurality of logic cell areas, each of the plurality of logic cell areas comprising a logic cell;
a switch cell area between the plurality of logic cell areas;
a plurality of first power rails extending in a first horizontal direction and configured to provide a first power supply voltage that is applied thereto; and
a plurality of second power rails extending in the first horizontal direction and configured to provide a second power supply voltage that is applied thereto,
wherein the switch cell area comprises:
a switch cell comprising:
a power line configured to provide a global power supply voltage that is applied thereto, and
a plurality of P-type transistors connected to the plurality of first power rails;
a power tap cell comprising a global via structure electrically connecting the power line to a back-side pattern; and
a switch dummy cell electrically separating the logic cell from the switch cell, and
wherein an N-type well region comprising a jog pattern is provided in the switch dummy cell.
